# EUROPEAN PATENT SPECIFICATION

(11) **EP 1 028 611 B1**
(45) Date of publication and mention of the grant of the patent: **09.06.2004**
(21) Application number: 00201367.0
(22) Date of filing: 24.06.1998
(51) Int. Cl.: H05K 9/00

(54) **Electromagnetic wave shielding and light transmitting plate**
Elektromagnetische Wellen abschirmende lichtdurchlässige Platte
Plaque-écran électromagnétique transparente

(30) Priority: 24.06.1997 JP 16738397; 24.06.1997 JP 16738497; 25.06.1997 JP 16868797; 25.06.1997 JP 16868897; 24.09.1997 JP 25837697; 24.09.1997 JP 25837797; 24.09.1997 JP 25838097; 24.09.1997 JP 25838197
(43) Date of publication of application: 16.08.2000
(62) Divisional of application: 98304968.5
(73) Proprietor: Bridgestone Corporation, Tokyo (JP)
(72) Inventor: Yoshikawa, Masato, Kodaira-shi, Tokyo (JP); Saito, Shinji, Kodaira-shi, Tokyo (JP); Morimura, Yasuhiro, Kodaira-shi, Tokyo (JP)
(74) Representative: Jenkins, Peter David

(56) References cited:
- EP-A- 0 113 218
- EP-A- 0 353 887
- EP-A- 0 366 537
- WO-A-97/34459
- US-A- 4 246 613
- US-A- 4 247 737
- US-A- 4 661 856
- US-A- 4 785 136
- US-A- 4 865 892
- US-A- 4 943 477
- US-A- 5 288 558
- US-A- 5 334 800
- US-A- 5 552 178
- PATENT ABSTRACTS OF JAPAN vol. 018, no. 010 (E-1487), 10 January 1994 (1994-01-10) & JP 05 251890 A (MICHIO ARAI), 28 September 1993 (1993-09-28)
- PATENT ABSTRACTS OF JAPAN vol. 016, no. 480 (M-1321), 6 October 1992 (1992-10-06) & JP 04 175154 A (MICHIO ARAI), 23 June 1992 (1992-06-23)
- PATENT ABSTRACTS OF JAPAN vol. 017, no. 286 (M-1422), 2 June 1993 (1993-06-02) & JP 05 016281 A (NISSHA PRINTING CO LTD), 26 January 1993 (1993-01-26)
- PATENT ABSTRACTS OF JAPAN vol. 016, no. 178 (E-1196), 28 April 1992 (1992-04-28) & JP 04 022045 A (MATSUSHITA ELECTRON CORP), 27 January 1992 (1992-01-27)
- PATENT ABSTRACTS OF JAPAN vol. 018, no. 066 (E-1501), 3 February 1994 (1994-02-03) & JP 05 283890 A (SUMITOMO 3M LTD;OTHERS: 01), 29 October 1993 (1993-10-29)

## Description

The present invention relates to an electromagnetic-wave shielding and light transmitting plate and, more particularly, to an electromagnetic-wave shielding and light transmitting plate suitable for a front filter for a PDP (plasma display panel), which has good electromagnetic-wave shielding efficiency and light transparency.

Recently, with the spread of electronic appliances including office automation apparatuses and communication instruments, electromagnetic wave emission from these appliances have come into a problem. That is, adverse effect of electromagnetic wave to the human body is feared and it is also a problem that the electromagnetic wave affects precision apparatus to operate in wrong way.

In particular, a PDP, which is merchandised as a flat large display in current years, has large electromagnetic wave emission due to its operating mechanism. Therefore, plates having good electromagnetic-wave shielding efficiency and light transparency have developed and come into practical use. Such plates are also used as windows of a place where a precision apparatus is installed, such as in a hospital or in a laboratory.

A conventional electromagnetic-wave shielding and light transmitting plate typically comprises transparent base plates such as acrylic boards and a conductive mesh member like a wire netting and is formed by interposing the conductive mesh member between the transparent base plates and by integrating them.

The conductive mesh member conventionally used in the electromagnetic-wave shielding and light transmitting plate is a wire netting typically having a wire diameter between 30 and 500 µm and an open area ratio between about 30 % and about 60 %.

In the conventional electromagnetic-wave shielding and light transmitting plate using the conductive mesh member, however, the mesh member must be designed to have significantly small mesh size in order to provide sufficient electromagnetic-wave shielding efficiency. Since this means that a net is disposed in front of the PDP of an office automation apparatus, for example an image blurring phenomenon occurs so that distinct pictures can not be provided. Further, a phenomenon that the dots of the PDP and the grids of the mesh member produce interference fringes (so-called "moiré") also occurs and this phenomenon also makes the pictures unseemly.

The conventional electromagnetic-wave shielding and light transmitting plate is at disadvantages in that reflection of light on a display makes the pictures unseemly and in that the angle of visibility is small so that images on the display are not visible due to lateral incident light. Moreover, there is a problem that heat from the main body of an office automation apparatus results in overheating of the display.

JP 5-251890 describes an electromagnetic-wave shielding structure including a pattern-etched metal foil.

It is an aim of the present invention to solve the above conventional problems and to provide an electromagnetic-wave shielding and light transmitting plate suitable for an electromagnetic-wave shielding filter for a PDP, which has good electromagnetic-wave shielding efficiency and light transparency, which can provide distinct pictures, and which can yet be easily made.

It is another aim of the present invention to solve the above conventional problems and to provide an electromagnetic-wave shielding and light transmitting plate suitable for an electromagnetic-wave shielding filter for a PDP, which has both good electromagnetic-wave shielding efficiency and a large angle of visibility.

It is yet another aim of the present invention to solve the above conventional problems and to provide an electromagnetic-wave shielding and light transmitting plate suitable for an electromagnetic-wave shielding filter for a PDP, which has good electromagnetic-wave shielding efficiency and light transparency, which can provide distinct pictures, and which has adiathermancy.

The present invention provides an electromagnetic-wave shielding and light transmitting plate according to claim 1.

The use of pattern etching allows the metallic foil to be etched in any pattern configuration so that the degree of freedom for the line width, space, and opening configuration is significantly high as compared with a conductive mesh member. Therefore, the aforementioned electromagnetic-wave shielding and light transmitting plate is made possible by using such a metallic foil which has both good electromagnetic-wave shielding efficiency and good light transparency and which never causes moiré phenomena.

The conductive layer may be interposed between two transparent base plates. Further, the conductive layer may be disposed on one surface of one transparent base plate.

It is preferable that the metallic foil is formed in a predetermined pattern by steps of coating with photoresist, pattern exposure, and etching.

The resin for bonding the conductive layer is preferably ethylene-vinyl acetate copolymer (EVA).

The electromagnetic-wave shielding and light transmitting plate of the present invention has the following effects so that it is industrially useful, for example, as an electromagnetic-wave shielding filter for a PDP:
1. Selecting the configuration of the pattern etching of the conductive foil provides desired electromagnetic-wave shielding efficiency and good light transparency.
2. The moiré phenomenon due to the use of a conductive mesh member can be prevented so as to provide distinct pictures.

Figs. 1a and 1b are schematic sectional views showing embodiments of an electromagnetic-wave shielding and light transmitting plate according to the present invention;

Figs. 2a through 2f are plan views showing examples of etching patterns.

The electromagnetic-wave shielding and light transmitting plate of the present invention can be effectively used as a front filter for a PDP or as windows of a place where precision apparatus is installed, such as a hospital or an institute.

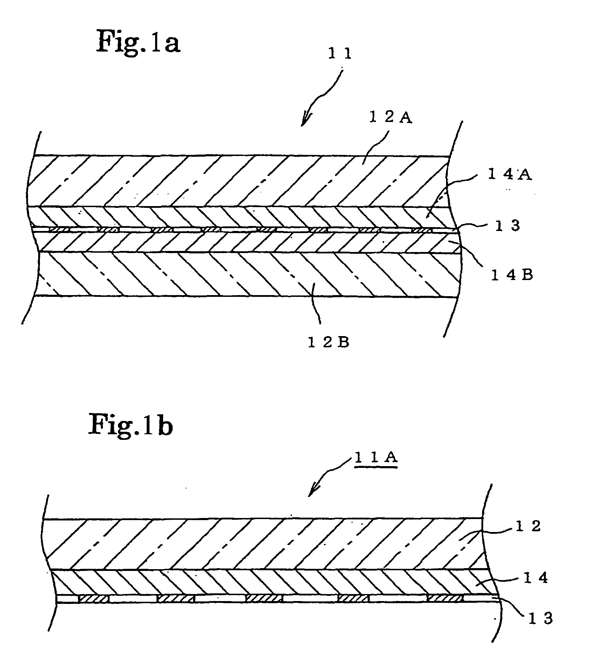

An electromagnetic-wave shielding and light transmitting plate 11 shown in Fig. 1a comprises two transparent base plates 12A, 12B, a metallic foil 13 as a conductive foil, and adhesive layers 14A, 14B and is formed by sandwiching the metallic foil 13 between the adhesive layers 14A and 14B, interposing them between the transparent base plates 12A and 12B, and by integrally bonding them.

An electromagnetic-wave shielding and light transmitting plate 11A shown in Fig. 1b comprises a transparent base plate 12, a metallic foil 13, and an adhesive layer 14 and is formed by bonding the metallic foil 13 to the adhesive layer 14 on one surface of the transparent base plate 12.

Examples of material of the transparent base plates 2A, 2B includes glass, polyester, polyethylene terephthalate (PET), polybutylene terephthalate, polymethyl methacrylate (PMMA), acrylic board, polycarbonate (PC), polystyrene, triacetate sheet, polyvinyl alcohol, polyvinyl chloride, polyvinylidene chloride, polyethylene, ethylene-vinyl acetate copolymer, polyvinylbutyral, metal ionic cross-linked ethylene-methacrylic copolymer, polyurethane, and cellophane. Preferably selected from the above materials are glass, PET, PC, and PMMA.

The thicknesses of the transparent base plates 2A, 2B are suitably determined in accordance with requirements (e.g. strength, light weight) due to the application of a plate to be obtained and are normally in a range from 0.05 to 5 mm.

The transparent base plates 12A, 12B are not necessarily made of the same material. For example, in a case of a PDP front filter of which only the front surface is required to have scratch resistance and durability, the transparent base plate 12A as the front surface may consist of a glass plate having a thickness of 1.0 to 4.0 mm and the transparent base plate 12B as the rear surface may consist of a PET board having a thickness of 0.05 to 0.3 mm.

The transparent base plate 12A as the front surface may be processed by hard coating with silicone oxide, soil resistant finish with polyvinylidene fluoride paint, AR (anti-reflection) coating with laminated layers of silicone dioxide layer and titanium dioxide layer, and/or anti- glare finish by hard coating including light-scattering agent or hard coating forming convexoconcaves to improve its function. On the other hand, the transparent base plate 12B as the rear surface may be processed by heat ray reflection coating with zinc oxide and silver film to improve its function.

In the structure shown in Fig. 1b, the transparent base plate 12 may be the same as the transparent base plate 12A as the front surface.

Examples of metal of the metallic foil include copper, stainless steel, aluminum, nickel, iron, brass, or alloy thereof. Preferably selected from the above are copper, stainless steel, and aluminum.

It is not preferable that the metallic foil is too thin in view of the handling and the working of pattern etching and it is also not preferable that the metallic foil is too thick because it affects the thickness of the electromagnetic-wave shielding and light transmitting plate to be obtained and makes a time period for etching process longer. Therefore, the thickness of the metallic foil is preferably in a range from 1 to 200 µm.

A method of pattern etching such a metal may be any one of commonly used methods and is preferably a photoetching using a resist. In this case, a resist pattern is formed by first coating the metallic foil with the photo-resist, exposing a pattern using a desired mask, and then developing the pattern. After that, metallic foil excepting places where the resist exists is removed by etchant such as ferric chloride.

The use of pattern etching can provide a high degree of freedom for pattern so that the metallic foil can be etched in any line width, space, and opening configuration, thereby preventing the moiré phenomenon, and allowing easy formation of an electromagnetic-wave shielding and light transmitting plate having desired electromagnetic-wave shielding efficiency and light transparency.

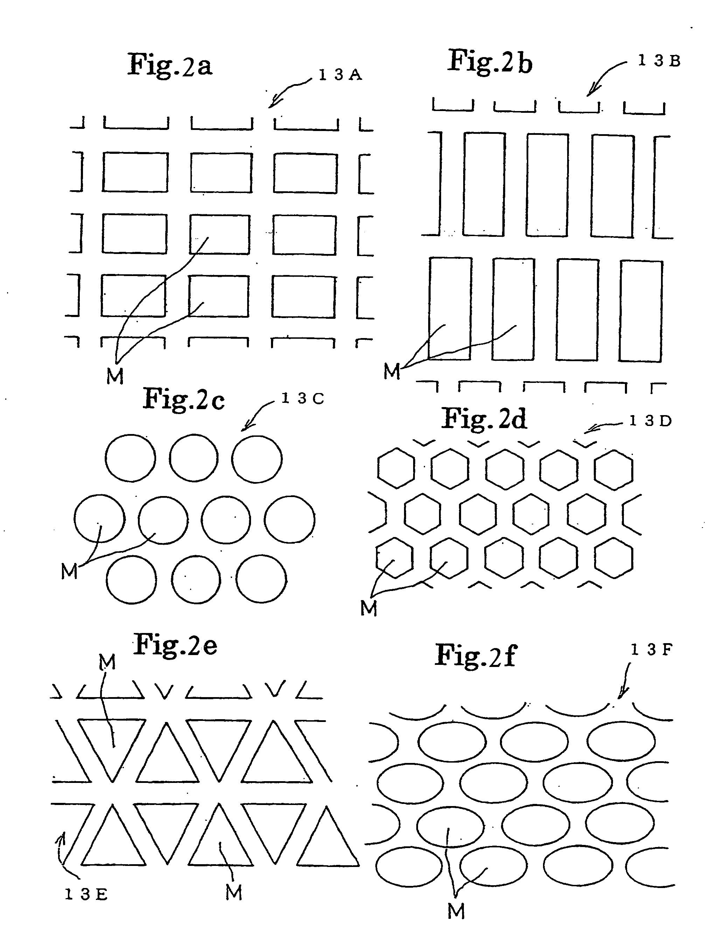

In the second aspect, the configuration of etching pattern of the metallic foil is not particularly limited. Examples include metallic foils 13A, 13B each formed in a lattice arrangement having rectangular openings M as shown in Figs. 2a, 2b and metallic foils 13C, 13D, 13E, 13F each formed in a punching metal-like arrangement having circular, hexagon, triangle, or elliptical openings M as shown in Figs. 2c, 2d, 2e and 2f. Besides the arrangements in which the openings M are regularly arranged, an arrangement in which openings M are randomly arranged may be used to prevent the moiré phenomenon.

In order to ensure the electromagnetic-wave shielding efficiency and the light transparency, the ratio of opening areas of the metallic foil relative to the projected area of the metallic foil (hereinafter, referred to as " open area ratio") is in the range from 83 to 90%.

The electromagnetic-wave shielding and light transmitting plate 11 of Fig. 1a can be easily made by sandwiching the pattern-etched metallic foil 13 between two adhesive films, in which crosslinking agent for heat curing are mixed to a EVA copolymer, interposing them between the transparent base plates 12A and 12B, then decompressing and deaerating them under the heated condition, and hardening the adhesive layer by heating or irradiation to integrate them.

The electromagnetic-wave shielding and light transmitting plate 11A of Fig. 2b can be easily made by pilling up the transparent base plate 12, such adhesive film 14 as mentioned above, and the pattern-etched metallic foil 13, and hardening them to integrate them in the same manner as mentioned above.

The thickness of each adhesive layer 14A, 14B, 14 can vary according to the application of the electromagnetic-wave shielding and light transmitting plate and is normally between 0.05 and 1.0 mm. Therefore, the adhesive film is formed to have a thickness from 0.05 to 1.0 mm to make an adhesive layer having such a thickness.

Hereinafter, the adhesive layer in which EVA is used as the resin will be described in detail.

EVA in which the contents of vinyl acetate is between 5 and 50 % by weight, preferably between 15 and 40 % by weight, is employed. Less than 5 % by weight of vinyl acetate interferes with the weatherability and the transparency, while exceeding 40 % by weight of vinyl acetate significantly reduces mechanical characteristics, makes the film forming difficult, and produce a possibility of blocking between sheets.

Suitably employed as the crosslinking agent when the EVA is crosslinked by heating is organic peroxide which is selected according to the temperature for sheet process, the temperature for crosslinking agent, and the storage stability. Examples of available peroxide includes 2,5-dimethylhexane-2,5-dihydro peroxide; 2,5-dimethyl-2,5-di (tert-butyl-peroxy)-hexane-3; di-tert-butyl peroxide; tert-butylcumyl peroxide; 2,5-dimethyl-2,5-di (tert-butyl-peroxy)-hexane; dicumyl peroxide; α,α'-bis (tert-butyl peroxy)-benzene; n-buthyl-4,4-bis (tert-butyl-peroxy)-valerate; 2,2-bis (tert-butyl-peroxy)-butane, 1,1-bis (tert-butyl-peroxy)-cyclohexane; 1,1-bis (tert-butyl-peroxy)-3,3,5- trimethylcyclohexane; tert-butyl peroxy benzoate; benzoyl peroxide; tert-butyl peroxy acetate; 2,5-dimethyl-2,5-bis (tert-butyl-peroxy)-hexyne-3; 1,1-bis (tert-butyl-and glycerin, or allyl group such as triallyl cyanurate, triallyl isocyanurate, diallyl phthalate, diallyl isophthalate, and diallyl maleate. These are used alone or in the mixed state, normally from 0.1 to 2 parts by weight, preferably from 0.5 to 5 parts by weight per100 parts by weight of EVA.

The EVA adhesive layer may further include, in small amounts, ultraviolet absorbing agent, infrared absorbing agent, antioxidant, paint processing aid, and/or coloring agent. If necessary, the EVA adhesive layer may still further include, in small amounts, filler such as hydrophobic silica and calcium carbonate.

It is also effective that an adhesive sheet made of the EVA is surfaced by corona discharge process, low temperature plasma process, electron beam irradiation process, or ultraviolet irradiation process as measures of improving the adhesive property.

The EVA adhesive film is made by first mixing the EVA and the additives, kneading them by an extruder or a roll, and after that, forming in a predetermined sheet configuration by means of a film forming method such as calendering, rolling, T-die extrusion, or inflation. During the film formation, embossing is provided for preventing the blocking and facilitating the deaerating during compressed onto the transparent base plates.

Hereinafter, the present invention will be more concretely described by means of an example and comparative examples.

Adhesive sheets used in the example and comparative examples were made as follows.

### Adhesive Sheet

Each adhesive sheet was made in such a way that 1 part by weight of 1,1-bis (tert-butyl-peroxy)-3,3,5- trimethylcyclohexane (Perhexa 3M available from NOF Corporation), 0.1 part by weight of γ-methacryloxypropyl trimethoxy silane, 2 parts by weight of diallyl phthalate, 0.5 part by weight of Sumisolve (available from Sumitomo Chemical Company, Limited.) as ultraviolet absorbing agent, and conductive particles specified in Table 1 at a ratio specified in Table 1 (no conductive particle in Comparative Examples 1 through 3) were added into and mixed with 100 parts by weight of ethylene-vinyl acetate copolymer (Ultrasen 634 available from Tosoh Corporation: 26 % content of vinyl acetate, Melt index 4) and the resultant mixture was extruded by a 40 mm extruder so that an adhesive sheet having a thickness of 0.1 mm with the both surfaces being embossed was provided.

The front transparent base plate 12A was a glass plate having a thickness of 3.0 mm and the rear transparent base plate 12B was a PET sheet having a thickness of 0.1 mm. These plates 12A, 12B having a metallic film specified in Table 1 interposed between two adhesive sheets interposed between the plates were entered into a rubber bag which was then vacuumed to be deaerated and pre-compressed by heating them at 85 °C for 15 minutes. After that, the object thus pre-compressed was entered into an oven and heated at 150 °C for 15 minutes so that it is crosslinked and hardened to be integrated.

The resultant plate was measured for the respective electromagnetic-wave shielding effect in a range between 30 MHz and 300 MHz, its light transmittance, and its visibility (the presence or absence of moiré phenomenon) in the following manner.

### Electromagnetic-wave shielding effect

The attenuance of field of each sample was measured using EMI shield measuring equipment available from Anritsu Corporation in conformity with KEC measurement (Kansai Electronic Industrial Promotion Center). The size of the sample was 90 mm %110 mm.

### Light transmittance (%)

The average light transmittance in a range between 380nm and 780 nm was measured using a visible ultraviolet spectrophotometer (U-4000) available from Hitachi Ltd.

### Visibility

Each resultant plate was mounted on a display and it was then observed by the human eye whether interference fringe appeared on the display.

The results are tabulated in Table 1.

### Comparative Examples 1 through 3

Electromagnetic-wave shielding and light transmitting plates were made in the same manner as Example 1 but not using such a pattern-etched metallic foil or using a metal mesh specified in Table 2 instead of such a metallic foil. The characteristics were measured in the same manner and the results are tabulated in Table 2.

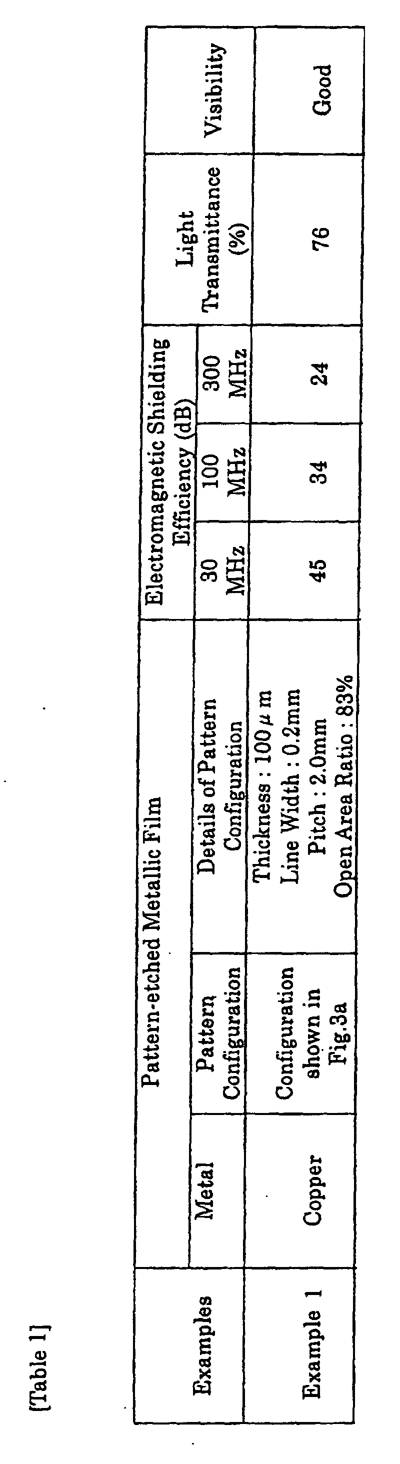

**[Table 2]**

| Examples | Conductive Mesh Member | Electromagnetic Shielding Efficiency (dB) | | | Light Transmittance (%) | Visibility |
|---|---|---|---|---|---|---|
| | | 30MHz | 100MHz | 300MHz | | |
| Comparative Example 1 | None | 24 | 14 | 3 | 92 | Good |
| Comparative Example 2 | Stainless Steel Mesh #17 Wire Diameter:0.14mm Open Area Ratio: 82% | 43 | 33 | 23 | 80 | Good |
| Comparative Example 3 | Stainless Steel Mesh #165 Wire Diameter: 0.05mm Open Area Ratio: 46% | 63 | 62 | 57 | 45 | Bad (moiré) |

It is apparent from Table 1 and Table 2 that good electromagnetic-wave shielding and light transmitting plates can be provided according to the present invention.

## Claims

1. A front filter for a plasma display panel including a transparent base plate (12A, 12B) having a pattern-etched conductive foil (13) bonded to the surface of the transparent base plate by resin (14A, 14B), **characterized in that** the pattern-etched conductive foil has an open area ratio in the range of 83 to 90%, and **in that** the resin is a heat-cured ethylene-vinyl acetate copolymer.

2. A front filter as claimed in claim 1, wherein said conductive foil is interposed between two transparent base plates (12A, 12B).

3. A front filter as claimed in claim 1, wherein said conductive foil is disposed on a single surface of a single transparent base plate.

4. A front filter as claimed in any one of claims 1 to 3, wherein said foil is a metallic foil which is formed in a predetermined pattern by steps of coating with photoresist, pattern exposure, and etching.

## Patentansprüche

1. Frontfilter für einen Plasmabildschirm, der eine transparente Basisplatte (12A, 12B) mit einer strukturgeätzten, leitfähigen Folie (13) aufweist, welche mit der Oberfläche der transparenten Basisplatte mittels einer Harzklebeschicht (14A, 14B) verbunden ist, **dadurch gekennzeichnet, dass** die strukturgeätzte, leitfähige Folie ein Freiflächenverhältnis im Bereich von 83 bis 90 % aufweist, und dass die Harzklebeschicht ein wärmeausgehärtetes Äthylenvinylacetat -Kopolymer ist.

2. Frontfilter nach Anspruch 1, wobei sich die leitfähige Folie zwischen zwei transparenten Basisplatten (12A, 12B) befindet.

3. Frontfilter nach Anspruch 1, wobei die leitfähige Folie auf einer einzigen Oberfläche von nur einer transparenten Basisplatte aufgebracht ist.

4. Frontfilter nach einem der Ansprüche 1 bis 3, wobei die Folie eine Metallfolie ist, die mit einem vorbestimmten Strukturmuster auf Grund der Schritte einer Beschichtung mit Photoresist, einer Strukturbelichtung und Strukturätzung gebildet ist.

## Revendications

1. Filtre avant pour un écran à plasma comprenant une plaque de base transparente (12A, 12B) ayant une feuille conductrice à motif gravé (13) liée à la surface de la plaque de base transparente par une résine (14A, 14B), **caractérisé en ce que** la feuille conductrice à motif gravé a un rapport d'aire ouvert dans la gamme de 83 à 90 % et **en ce que** la résine est un copolymère d'éthylène-acétate de vinyle thermodurci.

2. Filtre avant selon la revendication 1, dans lequel ladite feuille conductrice est interposée entre deux plaques de base transparentes (12A, 12B).

3. Filtre avant selon la revendication 1, dans lequel ladite feuille conductrice est disposée sur une seule surface d'une seule plaque de base transparente.

4. Filtre avant selon l'une quelconque des revendications 1 à 3, dans lequel ladite feuille est une feuille métallique qui est formée en un motif prédéterminé par des étapes de revêtement avec une résine photosensible, d'exposition de motif et de gravage.
